# FASCICULE DE BREVET EUROPEEN

(11) **EP 1 861 882 B1**
(45) Date de publication et mention de la délivrance du brevet: **09.07.2008**
(21) Numéro de dépôt: 06726258.4
(22) Date de dépôt: 20.03.2006
(51) Int. Cl.: H01L 31/18, H01L 31/20

(54) **PROCEDE DE FABRICATION D'UNE CELLULE PHOTOVOLTAIQUE A BASE DE SILICIUM EN COUCHE MINCE**
VERFAHREN ZUM HERSTELLEN EINER FOTOVOLTAISCHEN ZELLE AUF DER BASIS VON DÜNNFILM-SILIZIUM
METHOD FOR MAKING A PHOTOVOLTAIC CELL BASED ON THIN-FILM SILICON

(30) Priorité: 22.03.2005 FR 0550739
(43) Date de publication de la demande: 05.12.2007
(73) Titulaire: COMMISSARIAT A L'ENERGIE ATOMIQUE, 75015 Paris (FR)
(72) Inventeur: HUET, Stéphanie, F-45630 Beaulieu sur Loire (FR); JULIET, Pierre, F-38100 Grenoble (FR); DUCROS, Cédric, F-38690 Bevenais (FR); SANCHETTE, Frédéric, Le Vernay 38620 Montferrat (FR)
(74) Mandataire: Poulin, Gérard
(86) Numéro de dépôt international: PCT/FR2006/050239
(87) Numéro de publication internationale: WO 2006/100403

(56) Documents cités:
- EP-A- 1 100 130
- US-A- 5 714 404
- US-B1- 6 420 647
- ROSTALSKY M ET AL: "High rate deposition and electron beam recrystallization of silicon films for solar cells" PREPARATION AND CHARACTERIZATION, ELSEVIER SEQUOIA, NL, vol. 401, no. 1-2, 17 décembre 2001 (2001-12-17), pages 84-87, XP004312790 ISSN: 0040-6090 cité dans la demande
- TARDY, J., BARBIER, D., CACHARD, A, LAUGIER, A., FONTENILLE, J.: "Pulsed electron beam annealing of sputtered amorphous Si:H films" MAT. RES. BUL., vol. 16, no. 3, mars 1981 (1981-03), pages 347-352, XP002360123 USA
- DATABASE WPI Section PQ, Week 200254 Derwent Publications Ltd., London, GB; Class P81, AN 2002-497608 XP002360231 & KR 2002 005 815 A (SEMISYSCO CO LTD) 18 janvier 2002 (2002-01-18)

## Description

### DOMAINE TECHNIQUE

L'invention concerne un procédé de fabrication d'une cellule photovoltaïque à base de silicium en couche mince.

### ÉTAT DE LA TECHNIQUE ANTÉRIEURE

Le domaine de l'invention est celui de la fabrication de cellules photovoltaïques, qui permettent de convertir la lumière directement en électricité, déposées en couches minces sur un support par des procédés de dépôts sous vide (CVD : « Chemical Vapor Deposition » et PVD : « Physical Vapor Deposition ») et « au défilé ».

La technologie de fabrication de cellules photovoltaïques en couches minces, dont l'intérêt s'est révélé ces dernières années, concerne un type de cellule (ou module) obtenu par dépôt d'une couche mince de semi-conducteur sur un support. Le semi-conducteur est ainsi économisé car il n'est pas, comme pour des cellules au silicium cristallin, scié dans la masse. Cette technologie devrait permettre dans l'avenir de réduire significativement les coûts de production des cellules photovoltaïques.

Pour utiliser une telle technologie, différentes voies sont possibles :
- Silicium cristallin en couches minces
   On dépose alors une couche mince de silicium polycristallin de 5 à 50 µm d'épaisseur sur un substrat. De telles couches minces devraient permettre d'obtenir des rendements de conversion du même ordre qu'une cellule sur matériau massif, moyennant certaines adaptations technologiques (confinement optique, texturation...).
   Pour réaliser un tel dépôt, deux techniques sont actuellement possibles : la croissance par épitaxie en phase liquide (LPE) dont le principal inconvénient est l'utilisation d'un substrat cristallin et les techniques de dépôts CVD suivantes:
   - la décomposition pyrolytique du silane et de l'hydrogène sur un filament chaud de tungstène, qui permet de déposer du silicium microcristallin (µc-Si) sur un substrat de verre à 500°C à des vitesses relativement élevées (supérieures à 0.08 µm/min),
   - les dépôts chimiques en phase vapeur (CVD) à des températures supérieures à 800°C en présence d'un gaz contenant du silicium (silane ou chlorosilanes) et d'un gaz dopant (diborane ou phosphine respectivement pour le dopage P et N), dans lesquels la présence de gaz dangereux (silane) et toxiques (phosphine) présente une limitation à long terme sur le plan économique et environnemental,
   - les techniques les plus communes, qui sont les techniques CVD et notamment la technique PECVD (« Plasma Enhanced Chemical Vapor Deposition »), qui permettent de déposer des films silicium dans une gamme de températures comprises entre 300°C et 1200°C.

   Mais les rendements obtenus avec de telles techniques restent inférieurs à 10 % et ne passent à des valeurs de 13-16 % qu'avec une recristallisation (recuit thermique) pour augmenter la taille des grains. De meilleurs rendements sont attendus pour des cristallites de grandes dimensions (supérieures à 100 µm). Cependant les supports doivent pouvoir résister à des températures de 800°C environ afin de recristalliser le silicium : ils sont par exemple en céramique.
- Silicium amorphe en couches minces
   Le silicium amorphe, malgré sa structure désordonnée, possède un coefficient d'absorption supérieur à celui du silicium cristallin. Cependant, ce qu'il gagne en pouvoir d'absorption, il le perd en mobilité des charges électriques (rendement de conversion faible), un compromis restant toutefois viable. La fabrication de cellules photovoltaïques au silicium amorphe nécessite moins de silicium et moins d'énergie que celle de cellules au silicium cristallin.
   Mais avec ce type de matériau peu coûteux par rapport aux autres formes de silicium, on a des faibles rendements (7%). De plus des problèmes de stabilité apparaissent rapidement lorsqu'on expose celui-ci au soleil et aux intempéries. Des artifices technologiques tels que la superposition de deux structures p-i-n en « tandem » ou de trois couches actives très minces, peuvent être utilisées pour pallier ces inconvénients. La dégradation sous lumière peut alors être réduite de 30 % à 10 %.
   La structure la plus simple d'une cellule en silicium amorphe se compose d'une zone dopée bore, d'une zone intrinsèque et d'une zone dopée phosphore (structure p-i-n). Mais Les rendements industriels obtenus stagnent depuis des années sous la barre des 10 % au niveau des modules.
   De plus ces technologies font appel à des architectures complexes qui interviennent dans le coût de production.
   Ainsi les limitations technologiques des dispositifs de l'art connu ne permettent pas d'atteindre les objectifs suivants:
   - temps de vie supérieurs à 20 ans
   - coût de production de environ 0.5 euros/Wc pour un rendement de 13%. (Wc ou watt crête, étant une référence qui correspond à une puissance nominale délivrée par un générateur photovoltaïque dans les conditions optimales de fonctionnement).

   En effet:
   - Un dépôt de silicium par PECVD ne peut se faire à des vitesses suffisamment élevées (typiquement entre 0.01 et 0.1 µm/min).
   - La cristallisation du silicium est généralement réalisée par recuit thermique. Des technologies utilisant un recuit par laser ne permettent pas de contrôler la profondeur de pénétration de l'énergie laser. Le document référencé [1] en fin de désignation décrit le dépôt de couches de silicium nanocristallin sur des substrats en graphite par un procédé PECVD en chauffant le substrat. Ces couches sont alors recristallisées au moyen d'un procédé de cristallisation par faisceau d'électrons pulsé (PEB ou « Pulsed Electron Beam »). La présence de cristaux de silicium dans le matériau avant recristallisation favorise le processus de cristallisation. Mais les couches de silicium nanocristallin ont été élaborées par PECVD à l'aide de gaz dangereux et toxiques tels que le trichlorosilane (SiHCl₃) et l'hydrogène contrairement aux procédés de pulvérisation et d'évaporation. De plus, des températures élevées (entre 450 et 600°C) sont nécessaires pour obtenir ces films de silicium cristallisé.
- Le piégeage optique obtenu en réalisant une morphologie du support et du réflecteur arrière appropriée est peu développé. La texturation du support est généralement réalisée à l'aide de bains chimiques, qui sont des procédés polluants et caractérisés par des faibles vitesses.

Le document de M. Rostalsky et al., Preparation and Characterization, Elsevier Sequoia, NL, vol. 401, n° 1-2, pages 84-87 du 17 décembre 2001, décrit un procédé de fabrication d'une couche de silicium en couche mince.

La présente invention a pour objet de résoudre les problèmes énoncés ci-dessus en proposant un procédé de fabrication de cellules photovoltaïques en couches minces (procédés sous vide) à base de silicium sur un support bon marché et multifonctionnel (souple, incassable, excellente résistance mécanique).

### EXPOSÉ DE L'INVENTION

L'invention concerne un procédé de fabrication d'une cellule photovoltaïque à base de silicium en couche mince, dans lequel on réalise une hétérojonction par dépôt sur un support d'au moins une première couche en silicium amorphe dopé P(ou N) et d'une seconde couche en silicium amorphe dopé N (ou P), caractérisé en ce qu'on cristallise, au moins en partie, la au moins une première couche en utilisant une technologie de cristallisation du silicium par faisceau d'électrons pulsé et en ce que le dépôt de la première couche de silicium amorphe se fait per EBPVD ("Electron Beam Physical Vapour Deposition").

Avantageusement la seconde couche est une couche mince.

Avantageusement le procédé de l'invention comprend les étapes suivantes :
- texturation du support,
- dépôt d'une couche d'isolant,
- dépôt d'une couche réflectrice,
- dépôt d'au moins une couche de silicium amorphe dopé P (ou N),
- cristallisation, au moins en partie, de cette au moins une couche de silicium amorphe en utilisant une technologie de cristallisation du silicium par faisceau d'électrons pulsé,
- dépôt d'une couche mince de silicium amorphe dopée N (ou P),
- dépôt d'une couche d'oxyde transparent conducteur,
- dépôt d'une grille de contact,
- éventuellement encapsulation en utilisant une technologie de revêtement plasma ou revêtement polymère à l'atmosphère.

Avantageusement, après l'étape de dépôt d'une couche de réflecteur, on peut réaliser une étape de texturation de cette couche de réflecteur.

Avantageusement, après l'étape de dépôt d'une couche d'oxyde transparent conducteur, on peut réaliser une étape de dépôt d'une couche antiréflectrice.

Avantageusement, après cette étape de dépôt d'une couche antiréflectrice, on peut réaliser une étape de dépôt d'une couche de passivation.

Dans un exemple de réalisation avantageux :
- Le support est en acier inoxydable, en verre, en polymère, en céramique ou en un composite de plusieurs de ces éléments.
- La couche d'isolant est une couche de SiOₓ ou de SiOₓC_{y}H_{z}.
- La couche réflectrice est une couche métallique en Al, Mo ou Ag ou en céramique en TiN, ZrN ou Si₃N₄.
- La couche d'oxyde transparent conducteur est une couche d'ITO, ZnO, ZnO : Al, ou SnO₂.
- La grille de contact est en aluminium, en cuivre, ou en argent.
- Le dopant de type P utilisé pour doper le silicium amorphe est l'aluminium, l'indium, le gallium ou le bore.
- Le dopant de type N utilisé pour doper le silicium amorphe est le phosphore, l'antimoine ou l'arsenic.
- La couche antiréflectrice est une couche de TiO₂ ou Si₃N4.

Avantageusement l'ensemble des étapes du procédé est réalisé à une température inférieure à 450°. La première couche a une épaisseur de l'ordre de 10 microns. La seconde couche a une épaisseur de l'ordre du micron.

Un tel procédé présente de nombreux avantages :
- il utilise un support bas coût par exemple en acier inoxydable. C'est le meilleur support pour fabriquer des composants BIPV (« Building Integrated Photovoltaic ») car il présente notamment une très bonne tenue mécanique et en température.
- La solution d'un dépôt de silicium dopé en utilisant la technologie de pulvérisation cathodique d'évaporation sous vide, la projection thermique ou le dépôt chimique en phase vapeur (0.1 à 0.2 µm/min par pulvérisation avec seulement une cathode au lieu de 0.01 à 0.1 µm/min par PECVD) et en l'absence de gaz toxique permet d'obtenir des vitesses de dépôts élevées, notamment en multipliant le nombre de cathodes.
- La technologie de cristallisation du silicium de la couche de silicium amorphe par faisceau d'électrons pulsé constitue un atout majeur pour obtenir de meilleurs rendements par rapport aux technologies de l'art antérieur, en contrôlant une taille de cristallites large, qui peut atteindre typiquement plusieurs centaines de micromètres en largeur et plusieurs millimètres en longueur. Cette technologie est facilement intégrable dans un équipement « au défilé ».
- La réalisation de l'hétérojonction sur du silicium polycristallin permet de réduire considérablement le coût de la cellule photovoltaïque, du fait de la simplicité de son architecture. Contrairement aux procédés de l'art connu, dans lesquels on réalise l'hétérojonction avec du silicium cristallin, avec le procédé de l'invention on réalise celle-ci avec du silicium amorphe.
- La réalisation des couches de silicium amorphe est possible à basse température, ce qui est très intéressant d'un point de vue économique (faible dépense énergétique et coût de équipements diminué). Un dépôt de silicium à basse température permet, en effet, d'utiliser un support multifonctionnel bon marché, comme l'acier inoxydable, en respectant non seulement le substrat mais également les couches préalablement déposées.
- La technologie de « skin pass » utilisée pour la texturation au support est un procédé non polluant et rapide (300 m/min). Elle permet de réaliser une texturation contrôlée et plus fine du support de l'ordre de quelques micromètres (ou microns ou µm) au lieu de 10 à 50 µm obtenus avec des procédés des bains chimiques. De plus, une texturation supplémentaire du réflecteur arrière peut être réalisée pour améliorer le piégeage optique par un procédé de gravure par plasma.

### BRÈVE DESCRIPTION DES DESSINS

La figure 1 illustre une cellule photovoltaïque obtenue avec le procédé de l'invention.

Les figures 2A et 2B illustrent les spectres de diffraction de deux couches de silicium respectivement avant et après cristallisation.

### EXPOSÉ DÉTAILLÉ DE MODES DE RÉALISATION PARTICULIERS

La présente invention concerne un procédé de fabrication de cellules photovoltaïques à base de silicium en couche mince comprenant la réalisation d'une hétérojonction PN (ou NP) composée d'au moins une couche de silicium amorphe dopée P (ou N) au moins en partie cristallisée par faisceau d'électrons pulsé et d'une couche de silicium amorphe dopée N (ou P).

Le procédé de l'invention comprend les étapes suivantes :
1) texturation d'un support 10, par exemple en acier inoxydable en utilisant une technologie de déformation plastique de la surface, par exemple le « Skin Pass » ou le « IMPRINT »,
2) dépôt d'une couche d'isolant 11 (SiOₓ ou tout polymère plasma à base siloxane (SiO₂C_{y}H_{z}) comme l'hexaméthyldisiloxane (HMDSO)), en utilisant une technologie de dépôt physique ou chimique en phase vapeur,
3) dépôt d'une couche réflectrice 12 en métal (Ag, Mo, ou Al) en utilisant une technologie de pulvérisation cathodique, ou en céramique par pulvérisation cathodique réactive,
4) texturation facultative de cette couche de réflecteur en utilisant par exemple une technologie de gravure plasma,
5) dépôt d'au moins une première couche de silicium amorphe 13, cette couche étant dopée P (ou N) par technologie magnétron ou évaporation : Avantageusement, on utilise un dépôt par EBPVD (dépôt physique en phase vapeur par faisceau d'électrons; en anglais « Electron Beam Physical Vapor Deposition »). Ce procédé permet d'obtenir des vitesses de dépôt rapides (typiquement de l'ordre de 10nm/seconde, voire supérieure). On peut ainsi dans des délais industriellement raisonnables déposer des couches épaisses de matériau (typiquement de l'ordre de 10 microns), ce qui permet d'améliorer le rendement de l'hétérojonction. De plus, ce procédé peut être réalisé à basse température, notamment à température ambiante.
6) cristallisation, au moins en partie, de cette première couche 13 en utilisant une technologie de cristallisation du silicium par faisceau d'électron pulsé : Ce procédé de cristallisation permet de cristalliser des couches de silicium amorphe relativement épaisses (typiquement de l'ordre de 10 microns) sans échauffement significatif du substrat.
7) dépôt d'une seconde couche de silicium amorphe 14, cette couche étant dopée N (ou P), par dépôt physique ou chimique en phase vapeur : Le même procédé de dépôt que celui de la première couche peut être utilisé. Cette couche a typiquement une épaisseur de l'ordre de 1 micron qui associée à la couche cristallisée de 10 microns donne un bon rendement pour la jonction.
8) dépôt d'une couche d'oxyde transparent conducteur 15 en utilisant une technologie de dépôt physique ou chimique en phase vapeur (ITO, ZnO, ZnO : Al, ou SnO₂),
9) dépôt facultatif d'une couche antiréflectrice en utilisant une technologie de dépôt physique ou chimique en phase vapeur (TiO₂ ou Si₃N₄).
10) dépôt facultatif d'une couche de passivation en utilisant une technologie CVD,
11) dépôt d'une grille de contact 16, par exemple en aluminium, en cuivre ou en argent,
12) encapsulation de l'ensemble en utilisant une technologie de revêtement plasma ou de revêtement polymère à l'atmosphère.

L'ensemble des étapes du procédé décrit ci-dessus peut être réalisé à « basse température », typiquement sous 450°, et même 200°C. Il est donc compatible avec des substrats bas coût comme des substrats métalliques ou à base de polymères, qui ne supportent pas les températures couramment utilisées dans les procédés de réalisation de cellules à hétérojonction.

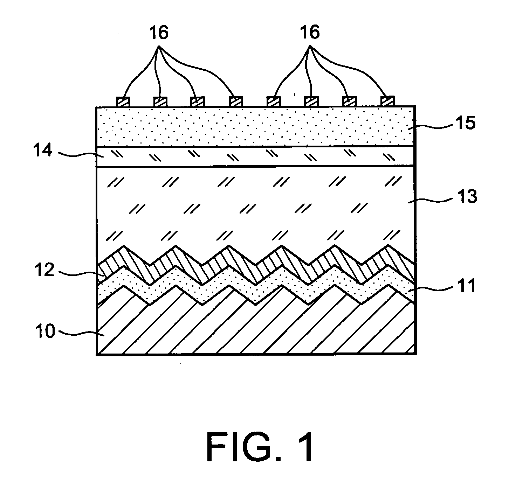

Comme illustré sur la figure 1, on obtient ainsi une cellule disposée sur un support 10 (feuille) en acier inoxydable texturé. Cette cellule comprend :
- une couche 11 d'isolant SiOₓ qui isole électriquement l'hétérojonction du support,
- un réflecteur arrière 12 qui sert également de barrière de diffusion et de contact électrique arrière, et qui peut être en aluminium (Al), en argent (Ag), en molybdène (Mo) ou en nitrure de titane (TiN),
- une première couche de silicium amorphe (a-Si : H) 13 dopée P (ou N) cristallisée, au moins en partie, par un faisceau d'électrons pulsé (en utilisant, par exemple, un dopant de type P tel que : l'aluminium, l'indium, le gallium, ou le bore),
- une seconde couche de silicium amorphe (a-Si : H) 14 dopée N (ou P) mince (en utilisant, par exemple, un dopant de type N tel que le phosphore, l'antimoine, ou l'arsenic),
- une couche de contact 15 d'oxyde transparent conducteur (TCO) (par exemple en ITO (Tin-doped indium oxide), ZnO, ZnO:Al, ou SnO₂),
- une grille de contact 16 par exemple en aluminium, pour collecter le courant.

Cette cellule peut comporter un ensemble de couches dont les épaisseurs sont, environ, les suivantes :
- support 10 :125µm
- couche d'isolant 11 : 0,5µm
- réflecteur arrière 12 : 1µm
- première couche de silicium amorphe 13 : 2 à 10µm
- seconde couche de silicium amorphe 14 : 10nm
- contact d'oxyde transparent conducteur 14 : 1µm.

Le procédé de l'invention est basé sur des technologies « couches minces » et sur l'emploi silicium cristallin. L'hétérojonction formée par la jonction couche 13-couche 14, est une architecture simple qui permet de limiter à la fois le coût de fabrication et les problèmes d'intégration des différentes couches constitutives de la cellule (contrairement aux jonctions tandem ou triple p-i-n). La technologie de cristallisation par faisceau d'électrons pulsé constitue un atout majeur pour le traitement contrôlé de couches minces. Elle permet de cristalliser rapidement et précisément la couche de silicium en contrôlant la profondeur de pénétration des électrons dans la matière et leur énergie (typiquement 10 eV/nm), ce qui n'est pas possible en utilisant des techniques classiques de recristallisation telles que la technologie laser ou thermique. Elle permet d'utiliser des supports bas coût en respectant la nature des supports et les couches préalablement déposées (couche isolante et réflecteur arrière), contrairement aux techniques de l'art antérieur (traitement thermique ou laser) qui imposent des supports résistants à des températures élevées tels que les céramiques, ainsi que des équipements coûteux permettant de résister à ces températures.

### Exemple de réalisation

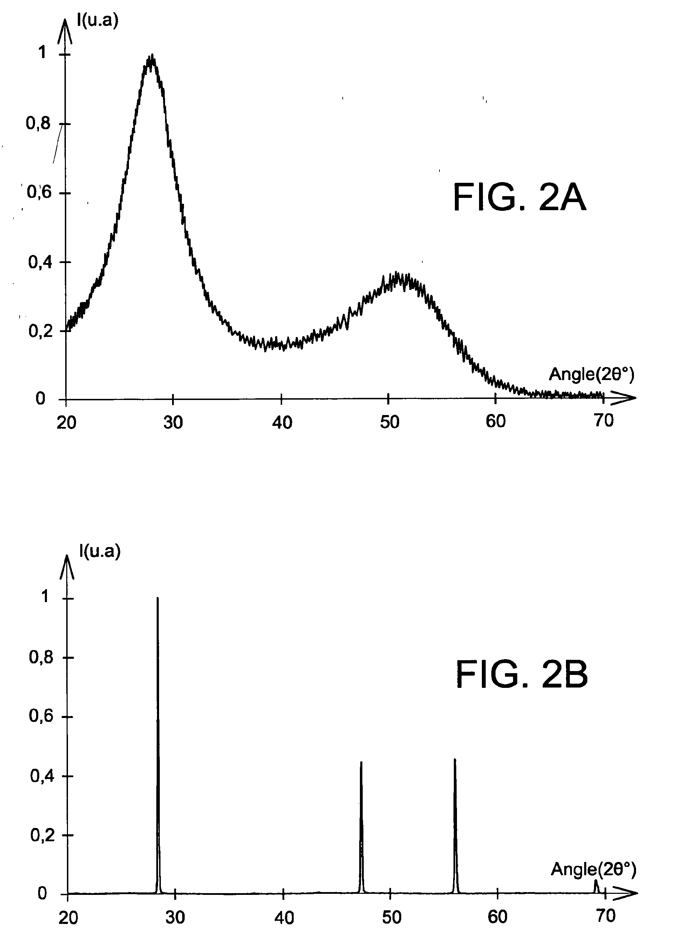

Sur les figures 2A et 2B sont représentés les spectres de diffraction X d'une couche de silicium respectivement avant et après cristallisation par faisceau d'électrons pulsé.

Le spectre de diffraction obtenu avant cristallisation est typique de celui d'un silicium amorphe a-Si : H. Le pic principal (raie 111) a une largeur à mi-hauteur de l'ordre de 10°.

Par contre, le spectre de diffraction obtenu après cristallisation par faisceau d'électron pulsé est typique d'une couche cristallisée. Le spectre de diffraction présente les pics caractéristiques des raies (111), (220) et (311). En particulier le pic principal (111) a une largeur à mi-hauteur de l'ordre de 0.05 à 1°, ce qui montre la qualité cristalline de la couche de silicium après cristallisation par faisceau d'électrons.

Les paramètres du faisceau d'électrons pulsé utilisé pour le recristallisation du silicium peuvent être les suivants : énergie des électrons 50-400 keV, courant du faisceau 200-500 A, section du faisceau 50-100 cm² ; durée d'une impulsion de 5 à 250 µs, densité de puissance maximale sur la cible 6MW/cm², densité d'énergie maximale 500 J/cm², tous ces paramètres étant contrôlés indépendamment.

### REFERENCE

[1] "High rate deposition and electron beam recrystallization of silicon films for solar cells", de M. Rostalsky et J. Müller (Thin Solid Films 401, 2001, pages 84-87).

## Revendications

1. Procédé de fabrication d'une cellule photovoltaïque à base de silicium en couche mince, dans lequel on réalise une hétérojonction par dépôt sur un support (10) d'au moins une première couche (13) en silicium amorphe dopé P (ou N) et d'une seconde couche (14) en silicium amorphe dopé N (ou P), **caractérisé en ce qu'**on cristallise, au moins en partie, la au moins une première couche (13) en utilisant une technologie de cristallisation du silicium par faisceau d'électrons pulsé et **en ce que** le dépôt de la première couche de silicium amorphe se fait par EBPVD.

2. Procédé selon la revendication 1, dans lequel la seconde couche (14) est une couche mince.

3. Procédé selon la revendication 1, qui comprend les étapes suivantes :
- texturation du support (10),
- dépôt d'une couche d'isolant (11),
- dépôt d'une couche réflectrice (12),
- dépôt d'au moins une couche (13) de silicium amorphe dopé P (ou N),
- cristallisation, au moins en partie, de cette au moins une couche (13) de silicium amorphe en utilisant une technologie de cristallisation du silicium par faisceau d'électrons pulsé,
- dépôt d'une couche mince (14) de silicium amorphe dopée N (ou P),
- dépôt d'une couche d'oxyde transparent conducteur (15),
- dépôt d'une grille de contact, conductrice (16).

4. Procédé selon la revendication 3 comprenant, en outre, une étape d'encapsulation en utilisant une technologie de revêtement plasma ou revêtement polymère à l'atmosphère.

5. Procédé selon la revendication 3, dans lequel, après l'étape de dépôt d'une couche de réflecteur (12), on réalise une étape de texturation de cette couche de réflecteur (12).

6. Procédé selon la revendication 3, dans lequel, après l'étape de dépôt d'une couche d'oxyde transparent conducteur (15), on réalise une étape de dépôt d'une couche antiréflectrice.

7. Procédé selon la revendication 6, dans lequel, après l'étape de dépôt d'une couche antiréflectrice, on réalise une étape de dépôt d'une couche de passivation.

8. Procédé selon la revendication 1, dans lequel le support (10) est en acier inoxydable, en métal, en verre, en polymère, en céramique ou en un composite de plusieurs de ces éléments.

9. Procédé selon la revendication 3, dans lequel la couche d'isolant (11) est une couche de SiOₓ ou SiOₓC_{y}H_{z}.

10. Procédé selon la revendication 3, dans lequel la couche réflectrice (12) est une couche métallique choisie en Al, Mo ou Ag.

11. Procédé selon la revendication 3, dans lequel la couche réflectrice (12) est une couche en céramique choisie parmi TiN, ZrN ou Si₃N₄.

12. Procédé selon la revendication 3, dans lequel la couche d'oxyde transparent conducteur est une couche d'ITO, ZnO, ZnO : Al, ou SnO₂.

13. Procédé selon la revendication 3, dans lequel la grille de contact (16) est en aluminium, en cuivre ou en argent.

14. Procédé selon la revendication 3, dans lequel le dopant de type P utilisé pour doper le silicium amorphe est l'aluminium, l'indium, le gallium ou le bore.

15. Procédé selon la revendication 3, dans lequel le dopant de type N utilisé pour doper le silicium amorphe est le phosphore, l'antimoine ou l'arsenic.

16. Procédé selon la revendication 6, dans lequel la couche antiréflectrice est une couche de TiO₂ ou de Si₃N4.

17. Procédé selon la revendication 3, dans lequel l'ensemble des étapes du procédé est réalisé à une température inférieure à 450°.

18. Procédé selon la revendication 1, dans lequel la première couche a une épaisseur de l'ordre de 10 microns.

19. Procédé selon la revendication 1, dans lequel la seconde couche a une épaisseur de l'ordre du micron.

## Claims

1. Method for making a photovoltaic cell based on thin film silicon, which consists in providing a heterojunction by depositing on a support (10) at least one first P- (or N-) doped amorphous silicon layer and a second N- (or P-) doped amorphous silicon layer (14), **characterized in that** the at least one first layer (13) is crystallised, at least partly, using a technology for crystallising silicon by pulsed electronic beam and **in that** the deposition of the first amorphous silicon layer is carried out by EBPVD.

2. Method according to claim 1, wherein the second layer (14) is a thin film.

3. Method according to claim 1, which comprises the following steps:
- texturing of the support (10),
- deposition of an insulating layer (11),
- deposition of a reflective layer (12),
- deposition of at least one P- (or N-) doped amorphous silicon layer (13),
- crystallisation, at least partly, of this at least one amorphous silicon layer (13) using a technology for crystallising silicon by pulsed electronic beam,
- deposition of a thin film (14) of N- (or P-) doped amorphous silicon,
- deposition of a transparent conductive oxide layer (15),
- deposition of a conductive contact gate (16).

4. Method according to claim 3 comprising, moreover, an encapsulation step by using an atmospheric plasma coating or polymer coating technology.

5. Method according to claim 3, wherein, after the step of depositing a reflective layer (12), a step of texturing this reflective layer (12) is carried out.

6. Method according to claim 3, wherein, after the step of depositing a transparent conductive oxide layer (15), a step of depositing an antireflective layer is carried out.

7. Method according to claim 6, wherein, after the step of depositing an antireflective layer, a step of depositing a passivation layer is carried out.

8. Method according to claim 1, wherein the support (10) is in stainless steel, in metal, in glass, in polymer, in ceramic or in a composite of several of these elements.

9. Method according to claim 3, wherein the insulating layer (11) is a layer of SiOₓ or SiOₓC_{y}H_{z}.

10. Method according to claim 3, wherein the reflective layer (12) is a metallic layer chosen among Al, Mo or Ag.

11. Method according to claim 3, wherein the reflective layer (12) is a ceramic layer chosen among TiN, ZrN or Si₃N₄.

12. Method according to claim 3, wherein the transparent conductive oxide layer is a layer of ITO, ZnO, ZnO:Al, or SnO₂.

13. Method according to claim 3, wherein the contact gate (16) is in aluminium, in copper or in silver.

14. Method according to claim 3, wherein the P-type dopant used to dope the amorphous silicon is aluminium, indium, gallium or boron.

15. Method according to claim 3, wherein the N-type dopant used to dope the amorphous silicon is phosphorous, antimony or arsenic.

16. Method according to claim 6, wherein the antireflective layer is a layer of TiO₂ or Si₃N₄.

17. Method according to claim 3, wherein all of the steps of the method are carried out at a temperature below 450°.

18. Method according to claim 1, wherein the first layer has a thickness of around 10 microns.

19. Method according to claim 1, wherein the second layer has a thickness of around a micron.

## Patentansprüche

1. Verfahren zur Herstellung einer photovoltaischen Zelle auf der Grundlage einer Siliziumdünnschicht, bei der ein Heteroübergang durch Auftrag wenigstens einer ersten Schicht (13) aus p- (oder n-) dotiertem, amorphem Silizium und einer zweiten Schicht (14) aus n- (oder p-) dotiertem, amorphem Silizium auf einen Träger (10) hergestellt wird, **dadurch gekennzeichnet, dass** die mindestens eine erste Schicht (13) unter Anwenden einer Siliziumkristallisationstechnik durch einen gepulsten Elektronenstrahl mindestens zum Teil kristallisiert wird und **dadurch**, dass der Auftrag der ersten Schicht aus amorphem Silizium durch EBPVD erfolgt.

2. Verfahren gemäß Anspruch 1, bei dem die zweite Schicht (14) eine Dünnschicht ist.

3. Verfahren gemäß Anspruch 1, das die folgenden Schritte umfasst:
- Texturierung des Trägers (10),
- Auftrag einer Isolierschicht (11),
- Auftrag einer reflektierenden Schicht (12),
- Auftrag wenigstens einer Schicht (13) aus p- (oder n-) dotiertem, amorphem Silizium,
- Kristallisation mindestens zum Teil dieser mindestens einen Schicht (13) aus amorphem Silizium unter Anwenden einer Siliziumkristallisationstechnik durch einen gepulsten Elektronenstrahl,
- Auftrag einer Dünnschicht (14) aus n- (oder p-) dotiertem, amorphem Silizium,
- Auftrag einer leitfähigen, transparenten Oxidschicht (15),
- Auftrag eines leitfähigen Kontaktgitters (16).

4. Verfahren gemäß Anspruch 3, das außerdem einen Schritt der Verkapselung unter Anwenden einer Plasmabeschichtungstechnik oder Polymerbeschichtung an der Luft umfasst.

5. Verfahren gemäß Anspruch 3, bei dem nach dem Schritt des Auftrags einer reflektierenden Schicht (12) ein Schritt der Texturierung der reflektierenden Schicht (12) durchgeführt wird.

6. Verfahren gemäß Anspruch 3, bei dem nach dem Schritt des Auftrags einer leitfähigen, transparenten Oxidschicht (15) ein Schritt des Auftrags einer Antireflexionsschicht durchgeführt wird.

7. Verfahren gemäß Anspruch 6, bei dem nach dem Schritt des Auftrags einer Antireflexionsschicht ein Schritt des Auftrags einer Passivierungsschicht durchgeführt wird.

8. Verfahren gemäß Anspruch 1, bei dem der Träger (10) aus Edelstahl, Metall, Glas, Polymer, Keramik oder einem Verbund mehrerer dieser Elemente ist.

9. Verfahren gemäß Anspruch 3, bei dem die Isolierschicht (11) eine SiOₓ- oder SiOₓC_{y}H_{z}-Schicht ist.

10. Verfahren gemäß Anspruch 3, bei dem die reflektierende Schicht (12) eine aus Al, Mo oder Ag ausgewählte Metallschicht ist.

11. Verfahren gemäß Anspruch 3, bei dem die reflektierende Schicht (12) eine aus TiN, ZrN oder Si₃N₄ ausgewählte Schicht ist.

12. Verfahren gemäß Anspruch 3, bei dem die leitfähige, transparente Oxidschicht eine Schicht aus ITO, ZnO, ZnO : Al oder SnO₂ ist.

13. Verfahren gemäß Anspruch 3, bei dem das Kontaktgitter (16) aus Aluminium, Kupfer oder Silber ist.

14. Verfahren gemäß Anspruch 3, bei dem das zum Dotieren des amorphen Siliziums verwendete Dotierungsmittel des p-Typs Aluminium, Indium, Gallium oder Bor ist.

15. Verfahren gemäß Anspruch 3, bei dem das zum Dotieren des amorphen Siliziums verwendete Dotierungsmittel des n-Typs Phosphor, Antimon oder Arsen ist.

16. Verfahren gemäß Anspruch 6, bei dem die Antireflexionsschicht eine TiO₂- oder Si₃N₄-Schicht ist.

17. Verfahren gemäß Anspruch 3, bei dem alle Schritte des Verfahrens bei einer Temperatur unter 450° durchgeführt werden.

18. Verfahren gemäß Anspruch 1, bei dem die erste Schicht eine Dicke in der Größenordnung von 10 Mikron aufweist.

19. Verfahren gemäß Anspruch 1, bei dem die zweite Schicht eine Dicke in der Größenordnung eines Mikrons aufweist.
